(19) Europäisches Patentamt
European Patent Office
Office européen des brevets

(11) EP 4 456 154 B1

(12) EUROPEAN PATENT SPECIFICATION

(45) Date of publication and mention of the grant of the patent:
**10.12.2025 Bulletin 2025/50**

(21) Application number: **24171885.7**

(22) Date of filing: **23.04.2024**

(51) International Patent Classification (IPC):
***C08K 5/1575*** $^{(2006.01)}$ ***C08L 23/06*** $^{(2006.01)}$
***C08K 5/053*** $^{(2006.01)}$

(52) Cooperative Patent Classification (CPC):
(C-Sets available)
**H10F 19/804;** C08K 5/0083; Y02E 10/50 (Cont.)

# (54) POLYETHYLENE RESIN COMPOSITION, FILM, SHEET, AND SOLAR CELL SEALING SHEET

POLYETHYLENHARZZUSAMMENSETZUNG, FOLIE, FLÄCHENGEBILDE UND FLÄCHENGEBILDE ZUM ABDICHTEN VON SOLARZELLEN

COMPOSITION DE RÉSINE DE POLYÉTHYLÈNE, FILM, FEUILLE ET FEUILLE D’ÉTANCHÉITÉ DE CELLULE SOLAIRE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **28.04.2023 JP 2023074787**

(43) Date of publication of application:
**30.10.2024 Bulletin 2024/44**

(73) Proprietor: **Sumitomo Chemical Company, Limited**
**Tokyo 103-6020 (JP)**

(72) Inventors:
- **YAMADA, Hidekazu**
  **Ichihara shi, Chiba, 299-0195 (JP)**
- **USA, Ayaka**
  **Ichihara shi, Chiba, 299-0195 (JP)**

(74) Representative: **Vossius & Partner Patentanwälte Rechtsanwälte mbB**
**Siebertstrasse 3**
**81675 München (DE)**

(56) References cited:
**WO-A1-2019/132694**
**CN-A- 114 292 439**
**JP-A- 2021 502 275**
**US-A1- 2015 024 197**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

**(Cont. next page)**

(52) Cooperative Patent Classification (CPC): (Cont.)

C-Sets
**C08K 5/053, C08L 23/06;**
**C08K 5/053, C08L 23/0815;**
**C08K 5/1575, C08L 23/06;**
**C08K 5/1575, C08L 23/0815**

## Description

BACKGROUND OF THE INVENTION

Field of the Invention

The present invention relates to a polyethylene resin composition, a film, a sheet, and a solar cell sealing sheet.

Description of the Related Art

Conventionally, an ethylene-based polymer has been used for a food packaging material, a pharmaceutical packaging material, an electronic component packaging material, a surface protective material, an insulator for an electric wire, a cable, or the like, a sheath, and the like.
For example, JP-A-2008-106264 describes an ethylene-α-olefin copolymer having excellent moldability and low fuming property during melt processing, and describes that the ethylene-α-olefin copolymer is used for a food packaging material. Further, WO 2019/132694 A1 discloses a composition characterized by a combination of the following features: high values of tensile strength, heat resistance, surface hardness, elasticity, and extensibility at low and ultralow temperatures, as well as high stress-cracking resistance and melt strength

SUMMARY OF THE INVENTION

In recent years, use of an ethylene-based polymer as a sealing material for a solar cell has been studied. The sealing material is required to have high heat resistance and high transparency, and a polyethylene resin composition capable of forming such a sealing material has been developed. In addition, high heat resistance and high transparency can be also required in applications other than the sealing material.
The present invention has been made in view of such a circumstance, and an object thereof is to provide a polyethylene resin composition having relatively excellent heat resistance and transparency, and a film, a sheet, and a solar cell sealing sheet using the polyethylene resin composition.
A polyethylene resin composition according to the present invention contains 100 parts by mass of an ethylene-based polymer having a Vicat softening point of 50°C or higher and 88°C or lower, and 0.01 parts by mass or more and 0.4 parts by mass or less of a compound represented by structural formula (I):

[Chemical formula 1]

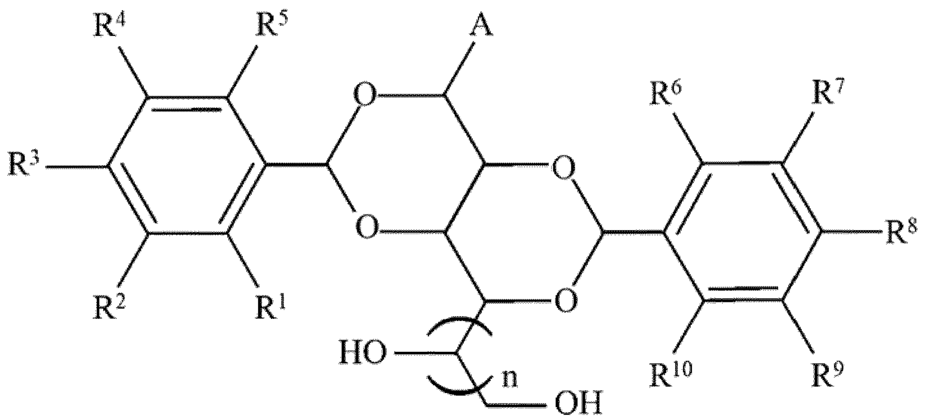

Structural formula (I)

in which n represents 0, 1, or 2, A represents a non-hydrogen group, $R^1$ to $R^{10}$ each independently represent a hydrogen atom, a halogen atom, a phenyl group, an alkyl group, an alkenyl group, an alkoxy group, or an acyl group, a hydrogen atom in the phenyl group, the alkyl group, the alkenyl group, the alkoxy group, and the acyl group may be replaced with a halogen atom, and any two adjacent groups may form a cyclic group with each other.
A film or sheet according to the present invention contains the above-described polyethylene resin composition.
A solar cell sealing sheet according to the present invention contains the above-described polyethylene resin composition.
The present invention can provide a polyethylene resin composition having relatively excellent heat resistance

and transparency, and a film, a sheet, and a solar cell sealing sheet using the polyethylene resin composition.

DETAILED DESCRIPTION OF THE PREFERRED EMBODIMENTS

Hereinafter, an embodiment of the present invention will be described, but the present invention is not limited to the following embodiment. Note that, hereinafter, "solar cell sealing sheet" may be simply referred to as "sealing sheet".

[Polyethylene resin composition]

A polyethylene resin composition according to the present embodiment contains an ethylene-based polymer and a compound represented by the following structural formula (I):

[Chemical formula 2]

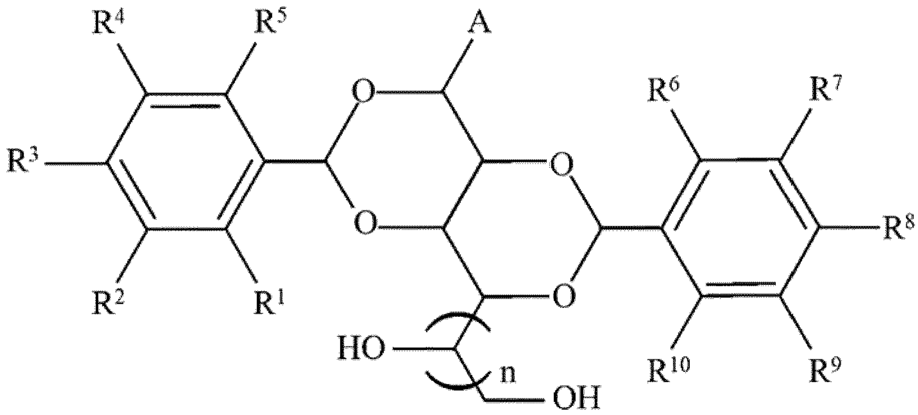

Structural formula (I)

in which n represents 0, 1, or 2, A represents a non-hydrogen group, $R^1$ to $R^{10}$ each independently represent a hydrogen atom, a halogen atom, a phenyl group, an alkyl group, an alkenyl group, an alkoxy group, or an acyl group, a hydrogen atom in the phenyl group, the alkyl group, the alkenyl group, the alkoxy group, and the acyl group may be replaced with a halogen atom, and any two adjacent groups may form a cyclic group with each other.

<Ethylene-based polymer>

The ethylene-based polymer is a polymer containing more than 50% by mass of monomer units based on ethylene. Examples of the ethylene-based polymer include an ethylene-$\alpha$-olefin copolymer, a high-pressure method low-density polyethylene (ethylene homopolymer), and an ethylene-unsaturated ester copolymer. The ethylene-based polymer is preferably an ethylene-$\alpha$-olefin copolymer from a viewpoint of improving moisture resistance and flexibility. Note that the ethylene-based polymer may be used singly or in combination of two or more types thereof.

The ethylene-based polymer according to the present embodiment has a Vicat softening point of 50°C or higher and 88°C or lower. The Vicat softening point of the ethylene-based polymer is preferably 52°C or higher and 87°C or lower, and more preferably 54°C or higher and 86°C or lower from a viewpoint of improving heat resistance and flexibility. The Vicat softening point can be adjusted by adjusting the content of a monomer unit based on an $\alpha$-olefin or an unsaturated ester in the ethylene-based polymer. Specifically, the Vicat softening point decreases as the content of a monomer unit based on an $\alpha$-olefin in an ethylene-$\alpha$-olefin copolymer increases. In addition, the Vicat softening point decreases as the content of a monomer unit based on an unsaturated ester in an ethylene-unsaturated ester copolymer increases.

The Vicat softening point (unit:°C) of the ethylene-based polymer is measured by the following method.

(Method for measuring Vicat softening point (unit:°C))

A sample of the ethylene-based polymer is pressed by hot pressing to form a sheet having a thickness of about 5 mm. The obtained sheet is measured in accordance with Method A50 defined in JIS K7206-1999.

A melt flow rate (hereinafter, also referred to as "MFR") of the ethylene-based polymer is preferably 0.10 g/10 min or more and 30.00 g/10 min or less, and more preferably 0.20 g/10 min or more and 10.00 g/10 min or less from a viewpoint

of improving extrusion processability. Note that the MFR is measured using a sample of the ethylene-based polymer in accordance with Method A defined in JIS K7210-1995 under conditions of a temperature of 190°C and a load of 2.16 kg.

The density of the ethylene-based polymer is preferably 940 kg/$m^3$ or less, more preferably 930 kg/$m^3$ or less, still more preferably 920 kg/$m^3$ or less, and particularly preferably 910 kg/$m^3$ or less from a viewpoint of increasing mechanical strength of an extruded compact. In addition, the density of the ethylene-based polymer is preferably 880 kg/$m^3$ or more, and more preferably 890 kg/$m^3$ or more from a viewpoint of enhancing heat resistance of an extruded compact. Note that the density is measured in accordance with a method defined in JIS K7112-1980 after annealing had been performed in accordance with JIS K6760-1995.

In one aspect, the density of the ethylene-based polymer is 880 kg/$m^3$ or more and 910 kg/$m^3$ or less.

<Ethylene-α-olefin copolymer>

The ethylene-α-olefin copolymer is an ethylene-α-olefin copolymer obtained by copolymerizing ethylene and an α-olefin preferably having 3 or more and 20 or less carbon atoms. Examples of the α-olefin having 3 or more and 20 or less carbon atoms include propylene, 1-butene, 1-pentene, 1-hexene, 1-heptene, 1-octene, 1-nonene, 1-decene, 1-dodecene, 4-methyl-1-pentene, and 4-methyl-1-hexene, and the α-olefin having 3 or more and 20 or less carbon atoms is preferably 1-butene, 1-hexene, 4-methyl-1-hexene, or 1-octene. The α-olefin having 3 or more and 20 or less carbon atoms may be used singly or in combination of two or more types thereof.

The content of a monomer unit based on ethylene in the ethylene-α-olefin copolymer is preferably 50% by mass or more and 99.5% by mass or less with respect to the total mass (100% by mass) of the ethylene-α-olefin copolymer, for example, from a viewpoint of achieving higher conversion efficiency of a solar cell and from a viewpoint of more effective prevention of cracking of a solar cell element at the time of sealing. The content of a monomer unit based on an α-olefin having 3 or more and 20 or less carbon atoms in the ethylene-α-olefin copolymer is preferably 0.5% by mass or more and 50% by mass or less with respect to the total mass (100% by mass) of the ethylene-α-olefin copolymer. Note that when the ethylene-α-olefin copolymer contains monomer units based on two or more types of α-olefins, the content of the monomer unit based on an α-olefin is the total amount of the monomer units based on the α-olefins in the ethylene-α-olefin copolymer. The content of the monomer unit based on ethylene and the content of the monomer unit based on an α-olefin are measured by infrared spectroscopy (IR method).

Examples of the ethylene-α-olefin copolymer include an ethylene-1-butene copolymer, an ethylene-1-hexene copolymer, an ethylene-4-methyl-1-pentene copolymer, an ethylene-1-octene copolymer, an ethylene-1-butene-1-hexene copolymer, an ethylene-1-butene-4-methyl-1-pentene copolymer, an ethylene-1-butene-1-octene copolymer, and an ethylene-1-hexene-1-octene copolymer, and the ethylene-α-olefin copolymer is preferably an ethylene-1-butene copolymer, an ethylene-1-hexene copolymer, an ethylene-4-methyl-1-pentene copolymer, an ethylene-1-butene-1-hexene copolymer, an ethylene-1-butene-1-octene copolymer, or an ethylene-1-hexene-1-octene copolymer. These ethylene-α-olefin copolymers may be used singly or in combination of two or more types thereof.

The density of the ethylene-α-olefin copolymer is preferably 940 kg/$m^3$ or less, more preferably 930 kg/$m^3$ or less, still more preferably 920 kg/$m^3$ or less, and particularly preferably 910 kg/$m^3$ or less from a viewpoint of increasing mechanical strength of an extruded compact. The density of the ethylene-α-olefin copolymer is preferably 880 kg/$m^3$ or more, and more preferably 890 kg/$m^3$ or more from a viewpoint of enhancing heat resistance of an extruded compact. The density is measured in accordance with Method A described in JIS K7112-1980 after annealing had been performed in accordance with JIS K6760-1995. In addition, the density can be adjusted by adjusting the content of the monomer unit based on ethylene in the ethylene-α-olefin copolymer.

A melt flow rate of the ethylene-α-olefin copolymer is preferably 0.01 g/10 min or more, and more preferably 0.1 g/10 min or more, for example, from a viewpoint of reducing an extrusion load at the time of manufacturing a sealing sheet. In addition, the melt flow rate of the ethylene-α-olefin copolymer is preferably 100 g/10 min or less, more preferably 50 g/10 min or less, still more preferably 30 g/10 min or less, and particularly preferably 10 g/10 min or less, for example, from a viewpoint of achieving higher mechanical strength of a sealing sheet. The MFR is measured at a temperature of 190°C under a load of 2.16 kg by Method A defined in JIS K7210-1995. In addition, the MFR can be adjusted, for example, by adjusting a hydrogen concentration or a polymerization temperature at the time of manufacturing the ethylene-α-olefin copolymer by polymerization, and the MFR of the ethylene-α-olefin copolymer increases as the hydrogen concentration and the polymerization temperature increase.

In one aspect, the ethylene-α-olefin copolymer satisfies, from a viewpoint of improving heat resistance, flexibility, and extrusion processability, both of the following requirements (i) and (ii):

(i) a Vicat softening point is 50°C or higher and 85°C or lower; and
(ii) a melt flow rate is 0.10 g/10 min or more and 30.00 g/10 min or less.

Examples of a method for manufacturing the ethylene-α-olefin copolymer include a method in which ethylene

and an $\alpha$-olefin are copolymerized in the presence of a polymerization catalyst using, as catalyst components, a solid particulate co-catalyst component (hereinafter, also referred to as "component (i)") obtained by causing a co-catalyst component such as an organoaluminum compound, an organoaluminumoxy compound, a boron compound, or an organozinc compound to be carried on a particulate carrier, and a metallocene complex (hereinafter, also referred to as "component (ii)") having a ligand having a structure in which two cyclopentadienyl type anion skeletons are bonded to each other by a crosslinking group such as an alkylene group or a silylene group.

Examples of the solid particulate co-catalyst component include a component obtained by mixing methylalumoxane with porous silica, and a component obtained by mixing diethyl zinc, water, and fluorinated phenol with porous silica.

Specific examples of the solid particulate co-catalyst component include the co-catalyst component (i) obtained by bringing diethyl zinc as component (a), fluorinated phenol as component (b), water as component (c), porous silica as component (d), and trimethyldisilazane ($((CH_3)_3Si)_2NH$) as component (e) into contact with each other.

Examples of the fluorinated phenol as component (b) include pentafluorophenol, 3,5-difluorophenol, 3,4,5-trifluorophenol, and 2,4,6-trifluorophenol. As the fluorinated phenol, two types of fluorinated phenols having different numbers of fluorine atoms are preferably used from a viewpoint of increasing flow activation energy (Ea) and molecular weight distribution (Mw/Mn) of the ethylene-$\alpha$-olefin copolymer. In this case, a molar ratio between a phenol having a large number of fluorine atoms and a phenol having a small number of fluorine atoms is usually 20/80 or more and 80/20 or less. The molar ratio is preferably 30/70 or more and 70/30 or less.

As the use amounts of component (a), component (b), and component (c), when a molar ratio among the use amounts of the components is represented by component (a) : component (b) : component (c) = 1 : y : z, y and z preferably satisfy the following formula:

$$|2 - y - 2z| \leq 1$$

in which y is preferably a number of 0.01 or more and 1.99 or less, more preferably a number of 0.10 or more and 1.80 or less, still more preferably a number of 0.20 or more and 1.50 or less, and particularly preferably a number of 0.30 or more and 1.00 or less.

The amount of component (d) used with respect to component (a) is such an amount that the number of moles of zinc atoms contained in particles obtained by contact between component (a) and component (d) is preferably 0.1 mmol or more, and more preferably 0.5 mmol or more and 20 mmol or less per g of the particles. The amount of component (e) used with respect to component (d) is preferably such an amount that the number of moles of component (e) is 0.1 mmol or more, and more preferably 0.5 mmol or more and 20 mmol or less per g of component (d).

Examples of the metallocene complex include: a zirconocene complex in which two indenyl groups are bonded to each other by an ethylene group, a dimethylmethylene group, or a dimethylsilylene group; a zirconocene complex in which two methylindenyl groups are bonded to each other by an ethylene group, a dimethylmethylene group, or a dimethylsilylene group; a zirconocene complex in which two methylcyclopentadienyl groups are bonded to each other by an ethylene group, a dimethylmethylene group, or a dimethylsilylene group; and a zirconocene complex in which two dimethylcyclopentadienyl groups are bonded to each other by an ethylene group, a dimethylmethylene group, or a dimethylsilylene group. Examples of a metal atom of component (ii) include zirconium and hafnium, and examples of the remaining substituent of the metal atom include a diphenoxy group and a dialkoxy group. Component (ii) is preferably ethylenebis(1-indenyl) zirconium diphenoxide.

In the polymerization catalyst obtained by using the solid particulate co-catalyst component and the metallocene complex, an organoaluminum compound may be appropriately used in combination as a catalyst component, and examples of the organoaluminum compound include triisobutylaluminum and trinormaloctylaluminum.

The use amount of the metallocene complex is preferably $5 \times 10^{-6}$ mol or more and $5 \times 10^{-4}$ mol or less per g of the solid particulate co-catalyst component. The use amount of the organoaluminum compound is preferably such an amount that the number of moles of aluminum atoms of the organoaluminum compound is 1 mol or more and 2000 mol or less per mol of metal atoms of the metallocene complex.

In the polymerization catalyst using the solid particulate co-catalyst component and the metallocene complex, an electron-donating compound may be appropriately used in combination as a catalyst component. Examples of the electron-donating compound include triethylamine and tri-normal-octylamine.

When two types of fluorinated phenols having different numbers of fluorine atoms are used as the fluorinated phenol as component (b), an electron-donating compound is preferably used.

The use amount of the electron-donating compound is usually 0.1 mol% or more and 10 mol% or less with respect to the number of moles of aluminum atoms of the organoaluminum compound used as the catalyst component. The use amount is preferably 0.2 mol% or more and 5 mol% or less with respect to the number of moles of aluminum atoms of the

organoaluminum compound used as the catalyst component from a viewpoint of increasing the molecular weight distribution (Mw/Mn) of the ethylene-α-olefin copolymer.

More specific examples of the method for manufacturing the ethylene-α-olefin copolymer include a method in which ethylene and an α-olefin having 3 or more and 20 or less carbon atoms are copolymerized in the presence of a catalyst obtained by bringing the co-catalyst component (i), a crosslinked bisindenyl zirconium complex, and an organoaluminum compound into contact with each other.

Examples of a polymerization method include a continuous polymerization method including molding of particles of an ethylene-α-olefin copolymer. Examples of the continuous polymerization method include continuous gas phase polymerization, continuous slurry polymerization, and continuous bulk polymerization, and the continuous polymerization method is preferably continuous gas phase polymerization. A gas phase polymerization reaction apparatus is usually an apparatus including a fluidized bed type reaction tank, and preferably an apparatus including a fluidized bed type reaction tank having an enlarged portion. In the apparatus including a fluidized bed type reaction tank, a stirring blade may be disposed in the reaction tank.

As a method for supplying the components of the polymerization catalyst used for manufacturing the ethylene-α-olefin copolymer to the reaction tank, usually, a method for supplying the components in a water-free state using an inert gas such as nitrogen or argon, hydrogen, ethylene, or the like, or a method for supplying the components in a solution or slurry state by dissolving or diluting the components in a solvent is used. The components of the polymerization catalyst may be supplied individually, or any components may be brought into contact with each other in advance in any order and supplied.

Prepolymerization may be performed before main polymerization is performed. A prepolymerized prepolymerization catalyst component is preferably used as a catalyst component or a catalyst in main polymerization. An α-olefin used in the main polymerization may be different from that used in the prepolymerization. The α-olefin prepolymerized with ethylene is preferably an α-olefin having 4 or more and 12 or less carbon atoms, and more preferably an α-olefin having 6 or more and 8 or less carbon atoms.

A polymerization temperature is usually lower than a temperature at which the ethylene-α-olefin copolymer is melted, preferably 0°C or higher and 150°C or lower, more preferably 30°C or higher and 100°C or lower, and still more preferably 50°C or higher and 90°C or lower. The polymerization temperature is preferably 60°C or higher and 85°C or lower from a viewpoint of widening the molecular weight distribution (Mw/Mn) of the ethylene-α-olefin copolymer.

Polymerization time (as average residence time in a case of a continuous polymerization reaction) is usually 1 hour or more and 20 hours or less. The polymerization time (average residence time) is preferably 2 hours or more and 10 hours or less from a viewpoint of widening the molecular weight distribution (Mw/Mn) of the ethylene-α-olefin copolymer.

In addition, for the purpose of adjusting melt fluidity of the ethylene-α-olefin copolymer, hydrogen may be added to a polymerization reaction gas as a molecular weight adjusting agent, or an inert gas may coexist in the polymerization reaction gas. A molar concentration of hydrogen in the polymerization reaction gas with respect to a molar concentration of ethylene in the polymerization reaction gas is usually 0.1 mol% or more and 3 mol% or less with respect to 100 mol% of the molar concentration of ethylene in the polymerization reaction gas. In addition, the molar concentration of hydrogen in the polymerization reaction gas is preferably 0.2 mol% or more and 2.5 mol% or less with respect to 100 mol% of the molar concentration of ethylene in the polymerization reaction gas from a viewpoint of widening the molecular weight distribution (Mw/Mn) of the ethylene-α-olefin copolymer.

<Ethylene homopolymer>

The ethylene homopolymer is preferably an ethylene homopolymer obtained by polymerizing ethylene by a high pressure method, and is, for example, an ethylene homopolymer manufactured by polymerizing ethylene at a polymerization pressure of 140 MPa or more and 300 MPa or less and a polymerization temperature of 200°C or higher and 300°C or lower in the presence of a radical generator using a tank type reactor or a tube type reactor.

The density of the ethylene homopolymer is preferably 920 $kg/m^3$ or more, more preferably 925 $kg/m^3$ or more, and still more preferably 928 $kg/m^3$ or more from a viewpoint of enhancing heat resistance. In addition, the density of the ethylene homopolymer is preferably 935 $kg/m^3$ or less, and more preferably 933 $kg/m^3$ or less from a viewpoint of improving transparency. Note that annealing is performed in accordance with JIS K6760-1995, and then the density is measured in accordance with Method A defined in JIS K7112-1980.

<Ethylene-unsaturated ester copolymer>

The ethylene-unsaturated ester copolymer is a copolymer containing a monomer unit based on ethylene and a monomer unit based on an unsaturated ester. The unsaturated ester is a compound having a vinyl group and an ester bond in a molecule thereof, and examples of the unsaturated ester include a carboxylic acid vinyl ester, an unsaturated carboxylic acid alkyl ester, and an unsaturated carboxylic acid glycidyl ester, and the unsaturated ester is preferably at

least one selected from the group consisting of a carboxylic acid vinyl ester and an unsaturated carboxylic acid alkyl ester. Examples of the carboxylic acid vinyl ester include vinyl acetate and vinyl propionate. Examples of the unsaturated carboxylic acid alkyl ester include methyl acrylate, ethyl acrylate, butyl acrylate, methyl methacrylate, and ethyl methacrylate. Examples of the unsaturated carboxylic acid glycidyl ester include glycidyl acrylate and glycidyl methacrylate. The unsaturated ester may be used singly or in combination of two or more types thereof.

Examples of the ethylene-unsaturated ester copolymer include an ethylene-vinyl acetate copolymer, an ethylene-vinyl propionate copolymer, an ethylene-methyl acrylate copolymer, an ethylene-ethyl acrylate copolymer, an ethylene-butyl acrylate copolymer, an ethylene-methyl methacrylate copolymer, an ethylene-ethyl methacrylate copolymer, an ethylene-glycidyl methacrylate copolymer, and an ethylene-vinyl acetate-methyl methacrylate copolymer. Note that the ethylene-unsaturated ester copolymer may be used singly or in combination of two or more types thereof.

The content of a monomer unit based on ethylene in the ethylene-unsaturated ester copolymer is preferably 65% by mass or more and 80% by mass or less, more preferably 67% by mass or more and 77% by mass or less, and still more preferably 68% by mass or more and 75% by mass or less with respect to the total mass (100% by mass) of the ethylene-unsaturated ester copolymer, for example, from a viewpoint of achieving better peelability of a sheet forming material from a roll at the time of manufacturing a sealing sheet and from a viewpoint of achieving higher conversion efficiency of a solar cell. The content of a monomer unit based on an unsaturated ester in the ethylene-unsaturated ester copolymer is preferably 20% by mass or more and 35% by mass or less, more preferably 23% by mass or more and 33% by mass or less, and still more preferably 25% by mass or more and 32% by mass or less with respect to the total mass (100% by mass) of the ethylene-unsaturated ester copolymer, for example, from a viewpoint of achieving better peelability of a sheet forming material from a roll at the time of manufacturing a sealing sheet and from a viewpoint of achieving higher conversion efficiency of a solar cell. Note that when the ethylene-unsaturated ester copolymer contains monomer units based on two or more types of unsaturated esters, the content of the monomer unit based on an unsaturated ester is the total amount of the monomer units based on the unsaturated esters in the ethylene-unsaturated ester copolymer. The content of the monomer unit based on ethylene and the content of the monomer unit based on an unsaturated ester are measured by infrared spectroscopy (IR method).

A melt flow rate of the ethylene-unsaturated ester copolymer is preferably 50 g/10 min or less, and more preferably 40 g/10 min or less, for example, from a viewpoint of achieving better peelability of a sheet forming material from a roll at the time of manufacturing a sealing sheet. The melt flow rate of the ethylene-unsaturated ester copolymer is preferably 4 g/10 min or more, and more preferably 5 g/10 min or more, for example, from a viewpoint of reducing an extrusion load at the time of manufacturing a sealing sheet. The MFR is measured at a temperature of 190°C under a load of 2.16 kg by a method defined in JIS K7210-1995. In addition, the MFR can be adjusted, for example, by adjusting a polymerization pressure and/or a polymerization temperature at the time of manufacturing the ethylene-unsaturated ester copolymer.

Examples of a method for manufacturing the ethylene-unsaturated ester copolymer include a method for copolymerizing ethylene and an unsaturated ester in the presence of a known radical generator.

In the above-described ethylene-based polymer, a plant-derived monomer, a fossil resource-derived monomer, a monomer obtained by chemical recycling, or the like can be used as a monomer such as ethylene, propylene, 1-butene, or 1-hexene.

The plant-derived monomer is derived from carbon circulating on the ground surface as plants/animals, and generally contains a certain ratio of carbon 14 (14C). Examples of a method for manufacturing the plant-derived monomer include known methods such as cracking of bionaphtha, vegetable oil, animal oil, and the like, dehydrogenation of biopropane and the like, a method for separating an alcohol from a fermentation product such as sugar extracted from a plant raw material such as sugar cane or corn, and subjecting the alcohol to a dehydration reaction, and a method for subjecting ethylene obtained from plant-derived ethanol and n-butene to a metathesis reaction.

The fossil resource-derived monomer is derived from carbon as an underground resource such as petroleum, coal, or natural gas, and hardly contains carbon 14 (14C) generally. Examples of a method for manufacturing the fossil resource-derived monomer include a known method such as a method for manufacturing an olefin by cracking of petroleum-derived naphtha, ethane, or the like, or dehydrogenation of ethane, propane, or the like.

The monomer obtained by chemical recycling is derived from carbon generated by decomposition, combustion, or the like of waste, and the content of carbon 14 (14C) in the monomer varies depending on the waste. Examples of a method for manufacturing the monomer obtained by chemical recycling include known methods such as a method for thermally decomposing waste plastic, a method for cracking waste vegetable oil, waste animal oil, and the like, and a method for subjecting waste such as garbage, biomass waste, food waste, waste oil, waste wood, paper waste, waste plastic, and the like to a gasification/alcohol conversion/dehydration reaction.

The plant-derived monomer, the fossil resource-derived monomer, and the monomer obtained by chemical recycling can be used in combination of two or more type thereof. For example, a combination of fossil resource-derived ethylene/plant-derived ethylene/chemical recycling ethylene or a combination of fossil resource-derived ethylene/plant-derived ethylene/chemical recycling ethylene/fossil resource-derived 1-hexene/plant-derived 1-hexene/chemical recycling 1-hexene can be used. In this case, as the plant-derived monomer, the fossil resource-derived monomer, and the monomer obtained by chemical recycling, two or more types of monomers individually manufactured may be mixed and used, or a mixture of two or more types of monomers obtained by mixing raw materials of the monomers, intermediates thereof, and the like may be manufactured and used.

In the ethylene-based polymer according to the present embodiment, carbon atoms constituting the ethylene-based polymer may be plant-derived carbon (14C) atoms or fossil resource-derived carbon atoms, or may contain both of these.

The concentration of carbon 14 (14C) contained in the ethylene-based polymer is determined as a percentage of modern carbon (pMC: unit%) by an accelerator mass spectrometry (AMS) method defined in ISO 16620-2: 2019.

The concentration of carbon 14 (14C) contained in the ethylene-based polymer is preferably 0.2 pMC (%) or more, more preferably 0.5 pMC (%) or more, still more preferably 1 pMC (%) or more, particularly preferably 5 pMC (%) or more, and most preferably 10 pMC (%) or more from a viewpoint of reducing an environmental load. The concentration of carbon 14 (14C) is preferably 99 pMC (%) or less, more preferably 95 pMC (%) or less, still more preferably 90 pMC (%) or less, particularly preferably 70 pMC (%) or less, and most preferably 50 pMC (%) or less from a viewpoint of reducing cost.

The concentration of carbon 14 (14C) contained in the ethylene-based polymer can be adjusted by changing a ratio among a plant-derived monomer, a fossil resource-derived monomer, and a monomer obtained by chemical recycling, which are used for manufacturing the ethylene-based polymer. More specifically, since carbon dioxide in the atmosphere contains carbon 14 (14C) at a certain ratio, it is known that a plant that grows by taking in carbon dioxide in the atmosphere, for example, corn or a tree contains 14C. Meanwhile, it is also known that carbon 14 (14C) is hardly contained in a fossil resource considered to have been stored in the ground for a long period of time, such as petroleum. Therefore, carbon 14 (14C) can be contained as a constituent element of the ethylene-based polymer by using a plant-derived material as a raw material of a monomer used for manufacturing the ethylene-based polymer.

As the ethylene-based polymer containing carbon 14 (14C), a commercially available ethylene-based polymer can be used. For example, "I'M GREEN" (green polyethylene) series manufactured by Braskem, "TRUCIRCLE" series manufactured by SABIC, and "CirculenRenew" series manufactured by LyondellBasell can be used.

<Compound represented by structural formula (I)>

In the structural formula (I), n represents 0, 1, or 2, preferably n represents 1.

A represents a non-hydrogen group. The non-hydrogen group A is preferably an alkyl group or an alkenyl group, wherein the alkyl group or the alkenyl group can optionally contain one or more (e.g., one) caternary oxygen atoms and wherein the alkyl group or the alkenyl group can be optionally substituted by one or more halogen atoms or one or more hydroxy groups. Preferred examples of the non-hydrogen group A include $-CH_3$, $-CH_2CH_3$, $-CH_2CH_2CH_3$, $-CH_2CH_2CH_2CH_3$, $-CH_2CH=CH_2$, $-CH(CH_3)CH=CH_2$, $-CH_2CH-X-CH_2-X'$, $-CH_2CH-X''-CH_2-CH_3$, $-CH_2CH-X'''-CH_2OH$, or $-CH-OH-CH-OH-CH_2-OH$. Here, X, X', X'' and X''' each represent a halogen atom or a halogenated hydrocarbon group having, for instance, 1 or more and 20 or less carbon atoms, preferably 1 or more and 8 or less carbon atoms, more preferably 1 or more and 4 or less carbon atoms, such as a halogenated alkyl group, and are each preferably a fluorine atom, a chlorine atom, a bromine atom, or a halogenated alkyl group containing a fluorine atom, a chlorine atom, or a bromine atom. The alkyl group preferably has 1 or more and 20 or less carbon atoms, more preferably 1 or more and 8 or less carbon atoms, even more preferably 1 or more and 4 or less carbon atoms. The alkenyl group preferably has 2 or more and 20 or less carbon atoms, more preferably 2 or more and 8 or less carbon atoms, even more preferably 2 or more and 4 or less carbon atoms. Preferably, the non-hydrogen group A is $-CH_3$, $-CH_2CH_3$, $-CH_2CH_2CH_3$, or $-CH_2CH_2CH_2CH_3$.

$R^1$ to $R^{10}$ each independently represent a hydrogen atom, a halogen atom, a phenyl group, an alkyl group, an alkenyl group, an alkoxy group, or an acyl group, and one or more hydrogen atom in the phenyl group, the alkyl group, the alkenyl group, the alkoxy group, and the acyl group may be replaced with a halogen atom. The halogen atom in $R^1$ to $R^{10}$ and the substituent thereof is preferably a fluorine atom. The alkyl group preferably has 1 or more and 20 or less carbon atoms, more preferably 1 or more and 8 or less carbon atoms, even more preferably 1 or more and 4 or less carbon atoms. The alkenyl group preferably has 2 or more and 20 or less carbon atoms, more preferably 2 or more and 8 or less carbon atoms, even more preferably 2 or more and 4 or less carbon atoms. An alkoxy group has the formula -O-alkyl, wherein the above definition of alkyl applies. An acyl group has the formula -C(=O)-alkyl, wherein the above definition of alkyl applies.

In $R^1$ to $R^{10}$, any two adjacent groups may form a cyclic group with each other. The cyclic group may be a 5-to 7-membered ring (preferably 6-membered ring). The 5- to 7-membered ring may by carbocyclic or heterocyclic. If the ring is heterocyclic it may contain one or more heteroatoms which are selected from N, O and S. The cyclic group can have one or more substituents which are selected from a halogen atom (such as fluorine).

In structural formula (I), preferably, n is 0, 1, or 2, $R^1$, $R^2$, $R^4$, $R^5$, $R^6$, $R^7$, $R^9$, and $R^{10}$ are each a hydrogen atom, and $R^3$, $R^8$, and A are each an alkyl group as defined above from a viewpoint of improving transparency.

The polyethylene resin composition according to the present embodiment contains 0.01 parts by mass or more and 0.4 parts by mass or less of a compound represented by structural formula (I) with respect to 100 parts by mass of an

ethylene-based polymer having a Vicat softening point of 50°C or higher and 88°C or lower. In addition, the polyethylene resin composition preferably contains 0.025 parts by mass or more and 0.3 parts by mass or less of the compound represented by structural formula (I), and more preferably contains 0.05 parts by mass or more and 0.2 parts by mass or less of the compound represented by structural formula (I) with respect to 100 parts by mass of the ethylene-based polymer from a viewpoint of improving transparency.

The Vicat softening point of the polyethylene resin composition is preferably 50°C or higher and 90°C or lower, more preferably 52°C or higher and 89°C or lower, and still more preferably 54°C or higher and 88°C or lower from a viewpoint of improving heat resistance and flexibility.

The polyethylene resin composition may contain an additive as necessary. Examples of the additive include an organic peroxide, a hindered amine-based light stabilizer, a crosslinking aid, an ultraviolet absorber, and a silane coupling agent.

(Organic peroxide)

An organic peroxide can be blended in the polyethylene resin composition. The organic peroxide is mainly used for crosslinking an ethylene-based polymer. As the organic peroxide, an organic peroxide having a decomposition temperature (temperature at which a half-life is one hour) of 70°C or higher and 180°C or lower, particularly 90 to 160°C can be used. Examples of such an organic peroxide include t-butylperoxyisopropyl carbonate, t-butylperoxy-2-ethylhexyl carbonate, t-butylperoxyacetate, t-butylperoxybenzoate, dicumyl peroxide, 2,5-dimethyl-2,5-di(t-butylperoxy) hexane, di-t-butyl peroxide, 2,5-dimethyl-2,5-di(t-butylperoxy) hexyne-3,1,1-di(t-butylperoxy)-3,3,5-trimethylcyclohexane, 1,1-di(t-butylperoxy) cyclohexane, methylethylketone peroxide, 2,5-dimethylhexyl-2,5-diperoxybenzoate, t-butylhydroperoxide, p-menthane hydroperoxide, benzoyl peroxide, p-chlorobenzoyl peroxide, t-butyl peroxyisobutyrate, hydroxyheptyl peroxide, and diclohexanone peroxide.

The content of the organic peroxide is preferably 0.2 parts by mass or more and 5 parts by mass or less, more preferably 0.5 parts by mass or more and 3 parts by mass or less, and still more preferably 1 part by mass or more and 2 parts by mass or less with respect to 100 parts by mass of the ethylene-based polymer. When the blending ratio of the organic peroxide is within the above range, the ethylene-based polymer is sufficiently and uniformly crosslinked.

(Hindered amine-based light stabilizer)

A hindered amine-based light stabilizer can be blended in the polyethylene resin composition. The hindered amine-based light stabilizer traps a radical species harmful to a polymer and prevents generation of a new radical. There are many types of hindered amine-based light stabilizers from a low-molecular-weight compound to a high-molecular-weight compound, but a conventionally known hindered amine-based light stabilizer can be used without particular limitation.

Examples of the low-molecular-weight hindered amine-based light stabilizer include: a mixture of 70% by mass of a reaction product (molecular weight: 737) of a decanedioic acid bis(2,2,6,6-tetramethyl-1(octyloxy)-4-piperidinyl) ester, 1,1-dimethylethyl hydroperoxide, and octane and 30% by mass of polypropylene; bis(1,2,2,6,6-pentamethyl-4-piperidyl) [[3,5-bis(1,1-dimethylethyl)-4-hydroxyphenyl] methyl] butyl malonate (molecular weight: 685); a mixture of bis(1,2,2,6,6-pentamethyl-4-piperidyl) sebacate and methyl -1,2,2,6,6-pentamethyl-4-piperidyl sebacate (molecular weight: 509); bis(2,2,6,6-tetramethyl-4-piperidyl) sebacate (molecular weight: 481); tetrakis(2,2,6,6-tetramethyl-4-piperidyl)-1,2,3,4-butanetetracarboxylate (molecular weight: 791); tetrakis(1,2,2,6,6-pentamethyl-4-piperidyl)-1,2,3,4-butanetetracarboxylate (molecular weight: 847); a mixture of 2,2,6,6-tetramethyl-4-piperidyl-1,2,3,4-butanetetracarboxylate and tridecyl-1,2,3,4-butanetetracarboxylate (molecular weight: 900); and a mixture (molecular weight: 900) of 1,2,2,6,6-pentamethyl-4-piperidyl-1,2,3,4-butanetetracarboxylate and tridecyl-1,2,3,4-butanetetracarboxylate.

Examples of the high-molecular-weight hindered amine-based light stabilizer include: poly[{6-(1,1,3,3-tetramethylbutyl) amino-1,3,5-triazine-2,4-diyl}{(2,2,6,6-tetramethyl-4-piperidyl) imino} hexamethylene {(2,2,6,6-tetramethyl-4-piperidyl) imino}] (molecular weight: 2,000 to 3,100); a polymer of dimethyl succinate and 4-hydroxy-2,2,6,6-tetramethyl-1-piperidine ethanol (molecular weight: 3,100 to 4,000); a mixture of N,N',N",N"'-tetrakis-4,6-bis-(butyl-(N-methyl-2,2,6,6-tetramethylpiperidin-4-yl) amino)-triazin-2-yl)-4,7-diazadecane-1,10-diamine (molecular weight: 2,286) and a polymer of the dimethyl succinate and 4-hydroxy-2,2,6,6-tetramethyl-1-piperidineethanol; a polycondensate of dibutylamine-1,3,5-triazine-N,N'-bis(2,2,6,6-tetramethyl-4-piperidyl-1,6-hexamethylenediamine and N-(2,2,6,6-tetramethyl-4-piperidyl) butylamine (molecular weight: 2,600 to 3,400); and a copolymer of ethylene and a cyclic aminovinyl compound such as 4-acryloyloxy-2,2,6,6-tetramethylpiperidine, 4-acryloyloxy-1,2,2,6,6-pentamethylpiperidine, 4-acryloyloxy-1-ethyl-2,2,6,6-tetramethylpiperidine, 4-acryloyloxy-1-propyl-2,2,6,6-tetramethylpiperidine, 4-acryloyloxy-1-butyl-2,2,6,6-tetramethylpiperidine, 4-methacryloyloxy-2,2,6,6-tetramethylpiperidine, 4-methacryloyloxy 1,2,2,6,6-pentamethylperidine, 4-methacryloyloxy-1-ethyl-2,2,6,6-tetramethylpiperidine, 4-methacryloyloxy-1-butyl-2,2,6,6-tetramethylpiperidine, 4-crotonoyloxy-2,2,6,6-tetramethylpiperidine, or 4-crotonoyloxy-1-propyl-2,2,6,6-tetramethylpiperidine. The hindered amine-based light stabilizer may be used singly or in combination of two or more types thereof.

Among these compounds, as the hindered amine-based light stabilizer, poly[{6-(1,1,3,3-tetramethylbutyl) amino-1,3,5-triazine-2,4-diyl}{ (2,2,6,6-tetramethyl-4-piperidyl) imino} hexamethylene {(2,2,6,6-tetramethyl-4-piperidyl) imino}] (molecular weight: 2,000 or more and 3,100 or less), a polymer of dimethyl succinate and 4-hydroxy-2,2,6,6-tetramethyl-1-piperidine ethanol (molecular weight: 3,100 or more and 4,000 or less), a mixture of N,N',N",N'"-tetrakis-4,6-bis-(butyl-(N-methyl-2,2,6,6-tetramethylpiperidin-4-yl) amino)-triazin-2-yl)-4,7-diazadecane-1,10-diamine (molecular weight: 2,286) and a polymer of the dimethyl succinate and 4-hydroxy-2,2,6,6-tetramethyl-1-piperidineethanol, a polycondensate of dibutylamine-1,3,5-triazine-N,N'-bis(2,2,6,6-tetramethyl-4-piperidyl-1,6-hexamethylenediamine and N-(2,2,6,6-tetramethyl-4-piperidyl) butylamine (molecular weight: 2,600 or more and 3,400 or less), and a copolymer of a cyclic aminovinyl compound and ethylene are preferably used. This is because these compounds prevent bleed-out of the hindered amine-based light stabilizer with time during use of a product. The hindered amine-based light stabilizer preferably has a melting point of 60°C or higher from a viewpoint of easily preparing the polyethylene resin composition.

In the polyethylene resin composition, the content of the hindered amine-based light stabilizer is preferably 0.01 parts by mass or more and 2.5 parts by mass or less, more preferably 0.01 parts by mass or more and 1.0 part by mass or less, still more preferably 0.01 parts by mass or more and 0.5 parts by mass or less, particularly preferably 0.01 parts by mass or more and 0.2 parts by mass or less, and most preferably 0.03 parts by mass or more and 0.1 parts by mass or less with respect to 100 parts by mass of the ethylene-based polymer.

By setting the content of the hindered amine-based light stabilizer to 0.01 parts by mass or more, a stabilization effect can be sufficiently obtained, and by setting the content to 2.5 parts by mass or less, discoloration of a resin due to excessive addition of the hindered amine-based light stabilizer can be suppressed. In the polyethylene resin composition, a mass ratio between the organic peroxide and the hindered amine-based light stabilizer is preferably 1 : 0.01 or more and 1 : 10 or less, and more preferably 1 : 0.02 or more and 1 : 6.5 or less. This makes it possible to remarkably suppress yellowing of the polyethylene resin composition.

(Crosslinking aid)

A crosslinking aid can be blended in the polyethylene resin composition. The crosslinking aid is effective for accelerating a crosslinking reaction and increasing the degree of crosslinking of the ethylene-based polymer. Specific examples of the crosslinking aid include a polyunsaturated compound such as a polyallyl compound or a poly(meth) acryloxy compound. More specific examples of the crosslinking aid include: a polyallyl compound such as triallyl isocyanurate, triallyl cyanurate, diallyl phthalate, diallyl fumarate, or diallyl maleate; a poly(meth)acryloxy compound such as ethylene glycol diacrylate, ethylene glycol dimethacrylate, or trimethylolpropane trimethacrylate; and divinylbenzene. The crosslinking aid can be blended at a ratio of about more than 0 parts by mass and 5 parts by mass or less with respect to 100 parts by mass of the ethylene-based polymer according to the present embodiment.

(Ultraviolet absorber)

An ultraviolet absorber can be blended in the polyethylene resin composition. Examples of the ultraviolet absorber include various types of ultraviolet absorber such as a benzophenone-based ultraviolet absorber, a benzotriazole-based ultraviolet absorber, a triazine-based ultraviolet absorber, and a salicylic acid ester-based ultraviolet absorber.

Examples of the benzophenone-based ultraviolet absorber include 2-hydroxy-4-methoxybenzophenone, 2-hydroxy-4-methoxy-2'-carboxybenzophenone, 2-hydroxy-4-n-octoxybenzophenone, 2-hydroxy-4-n-dodecyloxybenzophenone, 2-hydroxy-4-n-octadecyloxybenzophenone, 2-hydroxy-4-benzyloxybenzophenone, 2-hydroxy-4-methoxy-5-sulfobenzophenone, 2-hydroxy-5-chlorobenzophenone, 2,4-dihydroxybenzophenone, 2,2'-dihydroxy-4-methoxybenzophenone, 2,2'-dihydroxy-4,4'-dimethoxybenzophenone, and 2,2',4,4'-tetrahydroxybenzophenone.

Examples of the benzotriazole-based ultraviolet absorber include a hydroxyphenyl-substituted benzotriazole compound such as 2-(2-hydroxy-5-methylphenyl) benzotriazole, 2-(2-hydroxy-5-t-butylphenyl) benzotriazole, 2-(2-hydroxy-3,5-dimethylphenyl) benzotriazole, 2-(2-methyl-4-hydroxyphenyl) benzotriazole, 2-(2-hydroxy-3-methyl-5-t-butylphenyl) benzotriazole, 2-(2-hydroxy-3,5-dit-amylphenyl) benzotriazole, or 2-(2-hydroxy-3,5-di-t-butylphenyl) benzotriazole. Examples of the triazine-based ultraviolet absorber include 2-[4,6-bis(2,4-dimethylphenyl)-1,3,5-triazin-2-yl]-5-(octyloxy) phenol and 2-(4,6-diphenyl-1,3,5-triazin-2-yl)-5-(hexyloxy) phenol. Examples of the salicylic acid ester-based ultraviolet absorber include phenyl salicylate and p-octylphenyl salicylate. The content of the ultraviolet absorber is preferably 2.0 parts by mass or less, more preferably 0.05 parts by mass or more and 2.0 parts by mass or less, still more preferably 0.1 parts by mass or more and 1.0 part by mass or less, particularly preferably 0.1 parts by mass or more and 0.5 parts by mass or less, and most preferably 0.2 parts by mass or more and 0.4 parts by mass or less with respect to 100 parts by mass of the ethylene-based polymer.

(Silane coupling agent)

In the polyethylene resin composition, a silane coupling agent can be used for the purpose of modifying a resin. Examples of the silane coupling agent used in the polyethylene resin composition include γ-chloropropyltrimethoxysilane, vinyltrichlorosilane; vinyltriethoxysilane, vinyltrimethoxysilane; vinyl-tris-(β-methoxyethoxy) silane, γ-methacryloxypropyltrimethoxysilane, β-(3,4-epoxycyclohexyl) ethyltrimethoxysilane, γ-glycidoxypropyltrimethoxysilane, vinyltriacetoxysilane, γ-mercaptopropyltrimethoxysilane, γ-aminopropyltrimethoxysilane, N-β-(aminoethyl)-γ-aminopropyltrimethoxysilane, and 3-acryloxypropyltrimethoxysilane. The silane coupling agent is preferably vinyltrimethoxysilane, γ-methacryloxypropyltrimethoxysilane, or 3-acryloxypropyltrimethoxysilane. The silane coupling agent is used preferably in an amount of more than 0 parts by mass and 5 parts by mass or less, more preferably in an amount of 0.01 parts by mass or more and 4 parts by mass or less, still more preferably in an amount of 0.01 parts by mass or more and 2 parts by mass or less, particularly preferably in an amount of 0.05 parts by mass or more and 1 part by mass or less with respect to 100 parts by mass of the ethylene-based polymer.

(Other additive components)

Another additional optional component can be blended in the polyethylene resin composition as long as the object of the present invention is not significantly impaired. Examples of such an optional component include an antioxidant, a crystal nucleating agent, a transparentizing agent, a lubricant, a colorant, a dispersant, a filler, a fluorescent whitening agent, an ultraviolet absorber, and a light stabilizer which are usually used for a usual polyolefin-based resin material.

In order to impart flexibility and the like, 3 parts by mass or more and 75 parts by mass or less of a lubricating oil, a crystalline ethylene-α-olefin copolymer polymerized by a Ziegler-based or metallocene-based catalyst, and/or a rubber-based compound such as an ethylene-α-olefin elastomer such as EBR or EPR, or a styrene-based elastomer such as SEBS or a hydrogenated styrene block copolymer can be blended in the polyethylene resin composition as long as the object of the present invention is not impaired.

Examples of a method for blending another additional optional component into the polyethylene resin composition include a known melt-kneading method. Examples of the method include a method in which dry blending is performed using a tumbler blender, a Henschel mixer, or the like, and then melt-kneading is further performed using a single screw extruder, a multi-screw extruder, or the like, and a method in which melt-kneading is performed using a kneader, a Banbury mixer, or the like.

The polyethylene resin composition according to the present embodiment is used for, for example, a sheet, a container, an insulator for an electric wire, a cable, or the like, a sheath, or a solar cell sealing material. As the solar cell sealing material, one obtained by pelletizing or sheeting a polyethylene resin composition can be used.

As a method for molding the polyethylene resin composition according to the present embodiment into various compacts, a known molding method can be used. Examples of the known molding method include an extrusion molding method and a coating extrusion molding method such as coating of an electric wire or a pipe.

[Film and sheet]

A film or sheet according to the present embodiment contains the above-described polyethylene resin composition.

The polyethylene resin composition according to the present embodiment can be used as a material for forming various films or sheets. A film formed using the polyethylene resin composition according to the present embodiment can be suitably used, for example, as a packaging material for food, medicine, or daily goods. A sheet formed using the polyethylene resin composition according to the present embodiment can be suitably used, for example, as a solar cell sealing sheet. Note that, in the present specification, the film thicknesses of the film and the sheet are not particularly limited, but for example, according to JIS Z 0108-2012, the film has a thickness of less than 250 μm, and the sheet has a thickness of 250 μm or more.

A method for manufacturing the film or the sheet is not particularly limited, and examples thereof include known methods for manufacturing a film or a sheet, and include an extrusion molding method such as an inflation method using an inflation film manufacturing apparatus or a T-die method using a T-die cast film manufacturing apparatus.

[Solar cell sealing sheet]

The solar cell sealing sheet according to the present embodiment contains the above-described polyethylene resin composition.

The polyethylene resin composition according to the present embodiment can be used as a material for forming

the solar cell sealing sheet. The solar cell sealing sheet formed using the polyethylene resin composition according to the present embodiment may be a multilayer sheet having a structure of skin layer-core layer-skin layer. The skin layer is formed on an outermost surface of the solar cell sealing sheet, and is preferably a layer having a relatively low density and a low melting point. The core layer is preferably a layer having a relatively high density and a high melting point. The polyethylene resin composition according to the present embodiment may be used for the skin layer or the core layer of the solar cell sealing sheet. The polyethylene resin composition according to the present embodiment may be used for both the skin layer and the core layer.

When the solar cell sealing sheet is a multilayer sheet having a structure of skin layer-core layer-skin layer, the core layer does not have to contain a crosslinking agent or a crosslinking aid.

The thickness of the core layer in the solar cell sealing sheet is preferably 0.2 mm or more and 0.4 mm or less, and more preferably 0.25 mm or more and 0.35 mm or less. The thickness of each of the skin layers is preferably 0.03 mm or more and 0.1 mm or less, and more preferably 0.035 mm or more and 0.080 mm or less. The total thickness of the two skin layers stacked on both surfaces of the core layer is preferably 1/20 or more and 1/3 or less, and more preferably 1/15 or more and 1/4 or less of the total thickness of the solar cell sealing sheet. By setting the thickness of each layer of the solar cell sealing sheet within such a range, heat resistance and molding characteristics of the solar cell sealing sheet can be maintained within favorable ranges.

The solar cell sealing sheet can be manufactured by a known sheet forming method using a T-die extruder, a calendering machine, or the like. Note that the formed sheet is wound around a paper tube for easy storage and transportation, but at this time, the sheets may adhere to each other (blocking may occur). When blocking occurs, the sheet cannot be stably fed when the sheet is fed and used in a next step, and productivity is lowered. Therefore, blocking is generally avoided by roughening a sheet surface or forming an uneven structure.

The present invention includes the following aspects.

[1] A polyethylene resin composition containing: 100 parts by mass of an ethylene-based polymer having a Vicat softening point of 50°C or higher and 88°C or lower; and 0.01 parts by mass or more and 0.4 parts by mass or less of a compound represented by structural formula (I):

[Chemical formula 3]

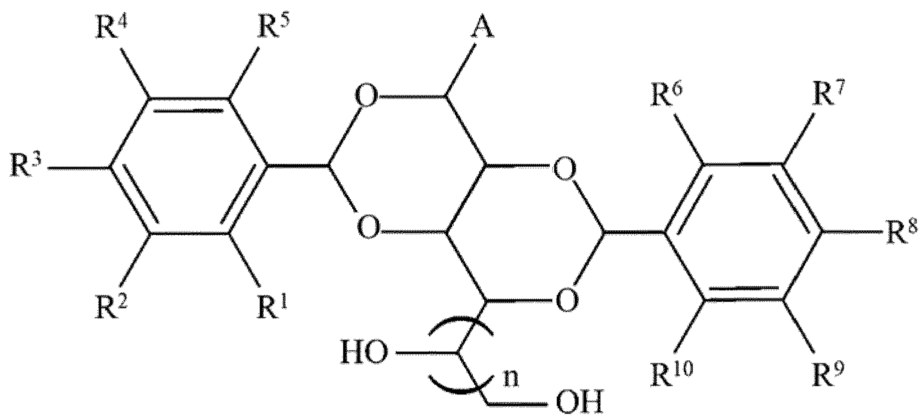

Structural formula (I)

in which n represents 0, 1, or 2, A represents a non-hydrogen group, $R^1$ to $R^{10}$ each independently represent a hydrogen atom, a halogen atom, a phenyl group, an alkyl group, an alkenyl group, an alkoxy group, or an acyl group, a hydrogen atom in the phenyl group, the alkyl group, the alkenyl group, the alkoxy group, and the acyl group may be replaced with a halogen atom, and any two adjacent groups may form a cyclic group with each other.

[2] The polyethylene resin composition according to [1], in which the polyethylene resin composition has a Vicat softening point of 50°C or higher and 90°C or lower.

[3] The polyethylene resin composition according to [1] or [2], in which the Vicat softening point of the ethylene-based polymer is 54°C or higher and 86°C or lower.

[4] The polyethylene resin composition according to any one of [1] to [3], in which the polyethylene resin composition has a Vicat softening point of 53°C or higher and 87°C or lower.

[5] The polyethylene resin composition according to any one of [1] to [4], in which the ethylene-based polymer has a density of 880 kg/$m^3$ or more and 910 kg/$m^3$ or less.

[6] The polyethylene resin composition according to any one of [1] to [5], in which the ethylene-based polymer has a density of 880 kg/$m^3$ or more and 900 kg/$m^3$ or less.
[7] The polyethylene resin composition according to any one of [1] to [6], in which the ethylene-based polymer is an ethylene-$\alpha$-olefin copolymer.
[8] The polyethylene resin composition according to [7], in which the ethylene-$\alpha$-olefin copolymer satisfies both of the following requirements (i) and (ii):

(i) a Vicat softening point is 50°C or higher and 85°C or lower; and
(ii) a melt flow rate is 0.10 g/10 min or more and 30.00 g/10 min or less.

[9] A film or sheet containing the polyethylene resin composition according to any one of [1] to [8].
[10] A solar cell sealing sheet containing the polyethylene resin composition according to any one of [1] to [8].

Examples

Hereinafter, the present invention will be described more specifically with reference to Examples, but the present invention is not limited to these Examples. Note that measured values of items in DETAILED DESCRIPTION OF THE PREFERRED EMBODIMENTS, Examples, and Comparative Examples were measured by the following methods.

(1) Method for measuring density (unit: kg/$m^3$)

Annealing was performed in accordance with JIS K6760-1995, and then a density was measured by Method A in accordance with a method defined in JIS K7112-1980.

(2) Method for measuring melt flow rate (MFR, unit: g/10 min)

A melt flow rate was measured in accordance with Method A defined in JIS K7210-1995 at a temperature of 190°C under a load of 2.16 kg.

(3) Method for measuring haze (unit: %)

A polyethylene resin composition was preheated for five minutes with a hot press machine at 150°C, then pressed at a pressure of 5 MPa for five minutes, and then allowed to cool for 15 minutes in a laboratory atmosphere (about 23°C) to form a sheet having a thickness of 0.5 mm. Haze of the formed sheet was measured in accordance with ASTM 1003 using a direct reading haze meter (manufactured by Toyo Seiki Seisaku-sho, Ltd.).

(4) Method for measuring tensile impact strength (unit: kJ/$m^2$)

A polyethylene resin composition was preheated for five minutes with a hot press machine at 150°C, then pressed at a pressure of 5 MPa for five minutes, and then allowed to cool for 15 minutes in a laboratory atmosphere (about 23°C) to form a sheet. Tensile impact strength of the formed sheet was measured by a tensile impact test in an atmosphere of 23°C in accordance with ASTM-D1822.

(5) Method for measuring volume resistivity (unit: $\Omega\cdot$cm)

A sheet having a thickness of 0.5 mm was formed by hot pressing. The formed sheet was placed on a large-diameter electrode SME-8310 for a flat plate sample (manufactured by HIOKI E.E. CORPORATION), and a voltage of 500 V was applied thereto at 23°C. After one minute, a resistance value was measured with a digital insulation meter SM-7110 (manufactured by HIOKI E.E. CORPORATION), and a volume resistivity value in accordance with JIS-K-6911 was calculated on the basis of the resistance value.

(6) Method for measuring Vicat softening point (VSP) (unit:°C)

An ethylene-based polymer or a polyethylene resin composition was pressed by hot pressing to form a sheet having a thickness of about 5 mm. A Vicat softening point of the obtained sheet was measured in accordance with Method A50 defined in JIS K7206-1999.
Materials used in Examples and Comparative Examples are as follows.

[Manufacture Example of ethylene-based polymer A-1]

(1) Manufacture of component (H)

Component (H) was manufactured by a similar method to preparation of component (A) in Examples 1(1) and 1(2) described in JP-A-2009-79180. As a result of elemental analysis, Zn = 11% by mass and F = 6.4% by mass were obtained.

(2) Manufacture of prepolymerization catalyst component

To an autoclave having an internal volume of 210 liters previously replaced with nitrogen and equipped with a stirrer, 41 liters of butane was added, and then 60.9 mmol of racemic ethylene bis(1-indenyl) zirconium diphenoxide was added thereto. The autoclave was heated to 50°C, and stirring was performed for two hours. Next, 0.60 kg of component (H) obtained above was added to the autoclave. Thereafter, the temperature of the autoclave was lowered to 31°C, and after the inside of the system was stabilized, 0.1 kg of ethylene and 0.1 liters of hydrogen (normal temperature and normal pressure) were added to the autoclave. Subsequently, 240 mmol of triisobutylaluminum was added thereto to initiate prepolymerization. Ethylene and hydrogen (normal temperature and normal pressure) were supplied to the autoclave at 0.5 kg/hr and 1.1 L/hr, respectively, for 30 minutes, then the temperature was raised to 50°C, and ethylene and hydrogen (normal temperature and normal pressure) were supplied to the autoclave at 2.7 kg/hr and 8.2 L/hr, respectively. Prepolymerization was performed for a total of 10.0 hours. After completion of the prepolymerization, ethylene, butane, hydrogen, and the like were purged, and the remaining solid was vacuum-dried at room temperature to obtain a prepolymerization catalyst component containing 4.14 g of polyethylene per g of component (H). The polyethylene had [$\eta$] of 1.26 dl/g.

(3) Manufacture of ethylene-based polymer A-1

In the presence of the prepolymerization catalyst component obtained in the above (2), copolymerization of ethylene and 1-hexene was performed with a continuous fluidized bed gas phase polymerization apparatus to obtain powder of an ethylene-1-hexene copolymer (hereinafter, referred to as ethylene-based polymer A-1). As polymerization conditions, polymerization temperature was set to 72°C, polymerization pressure was set to 2.0 MPa, a molar ratio of hydrogen to ethylene was set to 0.49%, and a molar ratio of 1-hexene to the total of ethylene and 1-hexene was set to 2.2%. Ethylene, 1-hexene, and hydrogen were continuously supplied in order to maintain a constant gas composition during the polymerization.

In addition, the prepolymerization catalyst component, triisobutylaluminum, and triethylamine were continuously supplied, and the total powder mass of 80 kg in the fluidized bed was maintained constant. The amount of triisobutylaluminum to ethylene-based polymer A-1 was set to 0.43 mmol/kg. A molar ratio of triethylamine to triisobutylaluminum was set to 3%. Average polymerization time was 5.0 hr. The obtained powder of ethylene-based polymer A-1 was granulated using an extruder (LCM50 manufactured by Kobe Steel, Ltd.) under conditions of a feed speed of 50 kg/hr, a screw rotation speed of 338 rpm, a gate opening of 50%, a suction pressure of 0.1 to 0.2 MPa, and a resin temperature of 180 to 200°C to obtain pellets of ethylene-based polymer A-1 (VSP: 54°C, MFR: 0.43 g/10 min, density: 890 kg/$m^3$).

[Manufacture Example of ethylene-based polymer A-2]

Ethylene-based polymer A-2 was manufactured under similar conditions to those of the manufacture of ethylene-based polymer A-2 except that the polymerization temperature was 77°C, the molar ratio of hydrogen to ethylene was 0.81%, the molar ratio of 1-hexene to the total of ethylene and 1-hexene was 2.5%, the amount of triisobutylaluminum to ethylene-based polymer A-1 was 0.38 mmol/kg, the molar ratio of triethylamine to triisobutylaluminum was 10%, and the average polymerization time was 4.1 hours to obtain pellets of ethylene-based polymer A-2 (VSP: 65°C, MFR: 0.55 g/10 min, density: 896 kg/$m^3$).

[Ethylene-based polymer A-3]

An ethylene-1-hexene copolymer (manufactured by Japan Polyethylene Corporation, VSP: 78°C, MFR: 2.2 g/10 min, density: 902 kg/$m^3$) was used.

[Ethylene-based polymer A-4]

An ethylene-1-octene copolymer (manufactured by The Dow Chemical Company, VSP: 86°C, MFR: 3.0 g/10

min, density: 902 kg/$m^3$) was used.

[Ethylene-based polymer A-5]

A high-pressure method low-density polyethylene (manufactured by Sumitomo Chemical Co., Ltd., VSP: 90°C, MFR: 3.5 g/10 min, density: 919 kg/$m^3$) was used.

[Ethylene-based polymer A-6]

An ethylene-1-hexene copolymer (manufactured by Sumitomo Chemical Co., Ltd., VSP: 47°C, MFR: 8.0 g/10 min, density: 880 kg/$m^3$) was used.

[Ethylene-based polymer A-7]

A high-pressure method low-density polyethylene (manufactured by Sumitomo Chemical Co., Ltd., VSP: 84°C, MFR: 7.0 g/10 min, density: 919 kg/$m^3$) was used.

[Nucleating agent B-1]

Nonitol,1,2,3-trideoxy-4,6:5,7-bis-O-[(4-propylphenyl) methylene] (manufactured by Milliken) was used.

[Nucleating agent B-2]

Bis(3,4-dimethylbenzylidene) sorbitol (manufactured by New Japan Chemical Co., Ltd.) was used.

[Nucleating agent B-3]

ADK STAB NA-21 (manufactured by ADEKA CORPORATION) was used.

[Nucleating agent B-4]

Hyperform (registered trademark) HPN-20E (manufactured by Milliken) was used.

[Manufacture Example of polyethylene resin composition]

[Example 1]

Nucleating agent B-1 (0.1 parts by mass) was mixed with ethylene-based polymer A-1 (100 parts by mass). The obtained mixture (100.1 parts by mass) was kneaded using Labo Plastomill R-100 (manufactured by Toyo Seiki Seisakusho, Ltd.) under conditions of 150°C, a rotation speed of 50 rpm, and five minutes to obtain a polyethylene resin composition 1. Physical properties of the obtained polyethylene resin composition 1 were evaluated and presented in Table 1.

[Examples 2 to 6]

Polyethylene resin compositions 2 to 6 were obtained under similar conditions to those of Example 1 except that the conditions presented in Table 1 were changed. Physical properties of the obtained polyethylene resin compositions 2 to 6 were evaluated and presented in Table 1.

[Comparative Examples 1 to 11]

Polyethylene resin compositions C1 to C11 were obtained under similar conditions to those of Example 1 except that the conditions presented in Table 2 were changed. Physical properties of the obtained polyethylene resin compositions C1 to C11 were evaluated and presented in Table 2.

[Table 1]

| | | | Example 1 | Example 2 | Example 3 | Example 4 | Example 5 | Example 6 |
|---|---|---|---|---|---|---|---|---|
| Resin composition | | | 1 | 2 | 3 | 4 | 5 | 6 |
| Composition ratio (parts by mass) | Ethylene-based polymer | A-1 | 100 | - | - | - | - | - |
| | | A-2 | - | 100 | 100 | - | - | - |
| | | A-3 | - | - | - | 100 | - | - |
| | | A-4 | - | - | - | - | 100 | - |
| | | A-5 | - | - | - | - | - | - |
| | | A-6 | - | - | - | - | - | - |
| | | A-7 | - | - | - | - | - | 100 |
| | Nucleating agent | B-1 | 0.100 | 0.100 | 0.050 | 0.100 | 0.075 | 0.075 |
| | | B-2 | - | - | - | - | - | - |
| | | B-3 | - | - | - | - | - | - |
| | | B-4 | - | - | - | - | - | - |
| Haze (%) | | | 6.1 | 6.2 | 11.8 | 6.2 | 9.6 | 28.6 |
| Tensile impact strength (kJ/m$^2$) | | | 1490 | 1450 | - | - | - | - |
| Volume resistivity (Ω·cm) | | | $4.16 \times 10^{17}$ | $4.00 \times 10^{17}$ | - | $2.38 \times 10^{14}$ | - | - |
| VSP (°C) | | | 54 | 64 | 63 | 76 | 86 | 84 |

[Table 2]

| | | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 | Comparative Example 11 |
|---|---|---|---|---|---|---|---|---|---|---|---|---|---|
| Resin composition | | | C1 | C2 | C3 | C4 | C5 | C6 | C7 | C8 | C9 | C10 | C11 |
| Composition ratio (parts by mass) | Ethylene-based polymer | A-1 | 100 | - | - | - | 100 | 100 | 100 | - | - | - | - |
| | | A-2 | - | 100 | - | - | - | - | - | 100 | - | - | - |
| | | A-3 | - | - | 100 | - | - | - | - | - | - | - | - |
| | | A-4 | - | - | - | 100 | - | - | - | - | - | - | - |
| | | A-5 | - | - | - | - | - | - | - | - | 100 | - | - |
| | | A-6 | - | - | - | - | - | - | - | - | - | 100 | - |
| | | A-7 | - | - | - | - | - | - | - | - | - | - | 100 |
| | Nucleating agent | B-1 | - | - | - | - | - | - | - | 0.500 | 0.100 | 0.100 | - |
| | | B-2 | - | - | - | - | 0.100 | - | - | - | - | - | - |
| | | B-3 | - | - | - | - | - | 0.100 | - | - | - | - | - |
| | | B-4 | - | - | - | - | - | - | 0.100 | - | - | - | - |
| Haze (%) | | | 13.1 | 23.1 | 21.2 | 54.5 | 22.7 | 13.9 | 30.5 | 35.5 | 66.4 | 9.2 | 70.2 |
| Tensile impact strength (kJ/m$^2$) | | | 1360 | 1330 | - | - | 1273 | 1320 | 1229 | - | - | - | - |
| VSP (°C) | | | 54 | 65 | 78 | 86 | 55 | 55 | 55 | 64 | 84 | 43 | 84 |

From Tables 1 and 2, it was indicated that the press sheets using the polyethylene resin compositions of Examples 1 to 6 satisfying all the constitutional requirements of the present invention maintained heat resistance because the press sheets had relatively high Vicat softening points. In addition, it was indicated that transparency of the press sheets using the polyethylene resin compositions of Examples 1 to 6 satisfying all the constitutional requirements of the present invention was improved because the press sheets had relatively low haze values. That is, the present invention can provide a polyethylene resin composition having relatively excellent heat resistance and transparency.

**Claims**

1. A polyethylene resin composition comprising: 100 parts by mass of an ethylene-based polymer having a Vicat softening point determined as described in the description of 50°C or higher and 88°C or lower; and

   0.01 parts by mass or more and 0.4 parts by mass or less of a compound represented by a structural formula (I):

   [Chemical formula 1]

   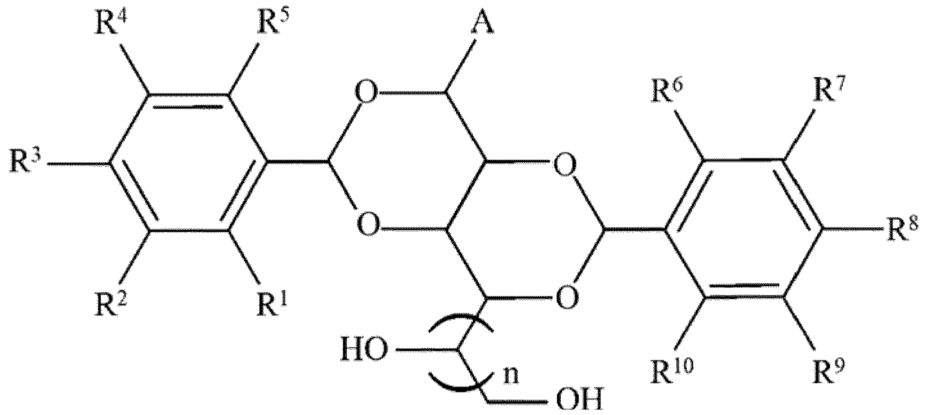

   Structural formula (I)

   wherein n represents 0, 1, or 2, A represents a non-hydrogen group, $R^1$ to $R^{10}$ each independently represent a hydrogen atom, a halogen atom, a phenyl group, an alkyl group, an alkenyl group, an alkoxy group, or an acyl group, a hydrogen atom in the phenyl group, the alkyl group, the alkenyl group, the alkoxy group, and the acyl group may be replaced with a halogen atom, and any two adjacent groups may form a cyclic group with each other.

2. The polyethylene resin composition according to claim 1, wherein the polyethylene resin composition has a Vicat softening point of 50°C or higher and 90°C or lower.

3. The polyethylene resin composition according to claim 1, wherein the Vicat softening point of the ethylene-based polymer is 54°C or higher and 86°C or lower.

4. The polyethylene resin composition according to claim 1, wherein the polyethylene resin composition has a Vicat softening point of 53°C or higher and 87°C or lower.

5. The polyethylene resin composition according to claim 1, wherein the ethylene-based polymer has a density determined as described in the description of 880 $kg/m^3$ or more and 910 $kg/m^3$ or less.

6. The polyethylene resin composition according to claim 1, wherein the ethylene-based polymer has a density determined as described in the description of 880 $kg/m^3$ or more and 900 $kg/m^3$ or less.

7. The polyethylene resin composition according to claim 1, wherein the ethylene-based polymer is an ethylene-$\alpha$-olefin copolymer.

8. The polyethylene resin composition according to claim 7, wherein the ethylene-$\alpha$-olefin copolymer satisfies both of the following requirements (i) and (ii):

   (i) a Vicat softening point is 50°C or higher and 85°C or lower; and
   (ii) a melt flow rate determined as described in the description under conditions of a temperature of 190°C and a load of 2.16 kg is 0.10 g/10 min or more and 30.00 g/10 min or less.

9. A film or sheet comprising the polyethylene resin composition according to any one of claims 1 to 8.

10. A solar cell sealing sheet comprising the polyethylene resin composition according to any one of claims 1 to 8.

## Patentansprüche

**1.** Eine Polyethylenharzzusammensetzung, umfassend: 100 Massenteile eines Polymers auf Ethylenbasis mit einem Vicat-Erweichungspunkt, bestimmt wie in der Beschreibung beschrieben, von 50°C oder mehr und 88°C oder weniger; und 0,01 Massenteile oder mehr und 0,4 Massenteile oder weniger einer Verbindung, dargestellt durch eine Strukturformel (I):

[Chemische Formel 1]

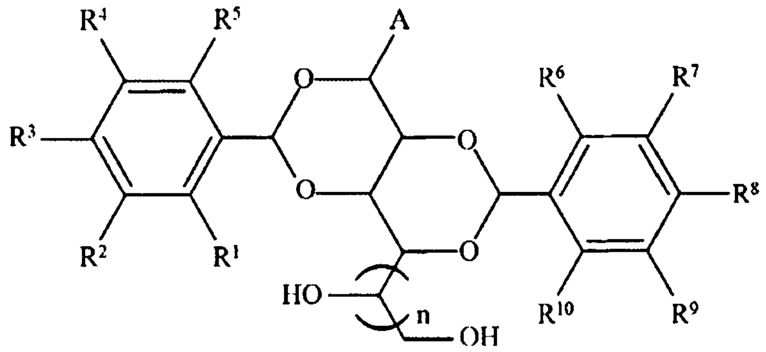

Strukturformel (I)

wobei n 0, 1 oder 2 darstellt, A eine Nicht-Wasserstoffgruppe darstellt, $R^1$ bis $R^{10}$ jeweils unabhängig ein Wasserstoffatom, ein Halogenatom, eine Phenylgruppe, eine Alkylgruppe, eine Alkenylgruppe, eine Alkoxygruppe oder eine Acylgruppe darstellen, wobei ein Wasserstoffatom in der Phenylgruppe, der Alkylgruppe, der Alkenylgruppe, der Alkoxygruppe und der Acylgruppe durch ein Halogenatom ersetzt sein kann und zwei beliebige benachbarte Gruppen miteinander eine cyclische Gruppe bilden können.

**2.** Die Polyethylenharzzusammensetzung nach Anspruch 1, wobei die Polyethylenharzzusammensetzung einen Vicat-Erweichungspunkt von 50°C oder mehr und 90°C oder weniger aufweist.

**3.** Die Polyethylenharzzusammensetzung nach Anspruch 1, wobei der Vicat-Erweichungspunkt des Polymers auf Ethylenbasis 54°C oder mehr und 86°C oder weniger beträgt.

**4.** Die Polyethylenharzzusammensetzung nach Anspruch 1, wobei die Polyethylenharzzusammensetzung einen Vicat-Erweichungspunkt von 53°C oder mehr und 87°C oder weniger aufweist.

**5.** Die Polyethylenharzzusammensetzung nach Anspruch 1, wobei das Polymer auf Ethylenbasis eine Dichte, bestimmt wie in der Beschreibung beschrieben, von 880 $kg/m^3$ oder mehr und 910 $kg/m^3$ oder weniger aufweist.

**6.** Die Polyethylenharzzusammensetzung nach Anspruch 1, wobei das Polymer auf Ethylenbasis eine Dichte, bestimmt wie in der Beschreibung beschrieben, von 880 $kg/m^3$ oder mehr und 900 $kg/m^3$ oder weniger aufweist.

**7.** Die Polyethylenharzzusammensetzung nach Anspruch 1, wobei das Polymer auf Ethylenbasis ein Ethylen-$\alpha$-Olefin-Copolymer ist.

**8.** Die Polyethylenharzzusammensetzung nach Anspruch 7, wobei das Ethylen-$\alpha$-Olefin-Copolymer beide der folgenden Anforderungen (i) und (ii) erfüllt:

(i) ein Vicat-Erweichungspunkt beträgt 50°C oder mehr und 85°C oder weniger; und
(ii) eine Schmelzflussrate, bestimmt wie in der Beschreibung beschrieben unter Bedingungen einer Temperatur von 190°C und einer Last von 2,16 kg, beträgt 0,10 g/10 min oder mehr und 30,00 g/10 min oder weniger.

**9.** Eine Folie oder ein Flächengebilde, umfassend die Polyethylenharzzusammensetzung nach einem der Ansprüche 1 bis 8.

**10.** Ein Flächengebilde zum Abdichten einer Solarzelle, umfassend die Polyethylenharzzusammensetzung nach einem der Ansprüche 1 bis 8.

## Revendications

**1.** Composition de résine de polyéthylène comprenant : 100 parties en masse d'un polymère à base d'éthylène ayant un point de ramollissement de Vicat déterminé comme décrit dans la description de 50°C ou plus et de 88°C ou moins ; et

0,01 parties en masse ou plus et 0,4 parties en masse ou moins d'un composé représenté par une formule structurelle (I) :

Formule chimique 1

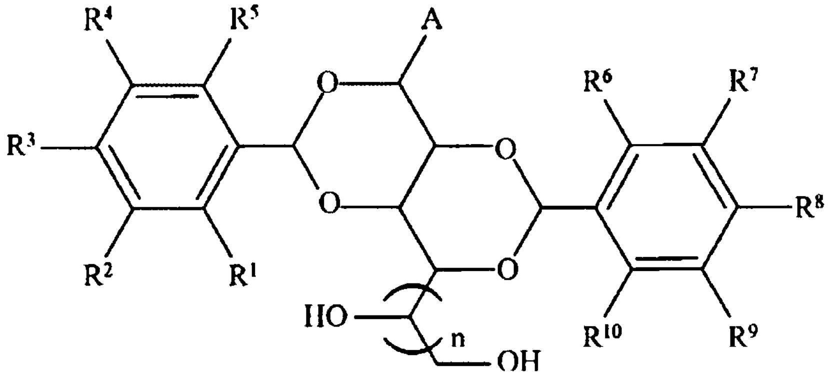

Formule structurelle (I)

dans laquelle n représente 0, 1, ou 2, A représente un groupe non hydrogène, $R^1$ à $R^{10}$ représentent chacun indépendamment un atome d'hydrogène, un atome d'halogène, un groupe phényle, un groupe alkyle, un groupe alcényle, un groupe alcoxy, ou un groupe acyle, un atome d'hydrogène dans le groupe phényle, le groupe alkyle, le groupe alcényle, le groupe alcoxy, et le groupe acyle peut être remplacé par un atome d'halogène, et deux groupes adjacents quelconques peuvent former un groupe cyclique l'un avec l'autre.

**2.** Composition de résine de polyéthylène selon la revendication 1, où la composition de résine de polyéthylène a un point de ramollissement de Vicat de 50°C ou plus et de 90°C ou moins.

**3.** Composition de résine de polyéthylène selon la revendication 1, dans laquelle le point de ramollissement de Vicat du polymère à base d'éthylène est de 54°C ou plus et de 86°C ou moins.

**4.** Composition de résine de polyéthylène selon la revendication 1, où la composition de résine de polyéthylène a un point de ramollissement de Vicat de 53°C ou plus et de 87°C ou moins.

**5.** Composition de résine de polyéthylène selon la revendication 1, dans laquelle le polymère à base d'éthylène a une densité déterminée comme décrit dans la description de 880 $kg/m^3$ ou plus et de 910 $kg/m^3$ ou moins.

**6.** Composition de résine de polyéthylène selon la revendication 1, dans laquelle le polymère à base d'éthylène a une densité déterminée comme décrit dans la description de 880 $kg/m^3$ ou plus et de 900 $kg/m^3$ ou moins.

**7.** Composition de résine de polyéthylène selon la revendication 1, dans laquelle le polymère à base d'éthylène est un copolymère à base d'éthylène - $\alpha$-oléfine.

**8.** Composition de résine de polyéthylène selon la revendication 7, dans laquelle le copolymère à base d'éthylène - $\alpha$-oléfine satisfait à la fois aux exigences suivantes (i) et (ii) :

(i) un point de ramollissement de Vicat de 50°C ou plus et de 85°C ou moins ; et
(ii) un indice de fluidité à chaud déterminé comme décrit dans la description dans des conditions d'une

température de 190°C et d'une charge de 2,16 kg est de 0,10 g/10 min ou plus et de 30,00 g/10 min ou moins.

**9.** Film ou feuille comprenant la composition de résine de polyéthylène selon l'une quelconque des revendications 1 à 8.

**10.** Feuille d'étanchéité de cellule solaire comprenant la composition de résine de polyéthylène selon l'une quelconque des revendications 1 à 8.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008106264 A
- WO 2019132694 A1
- JP 2009079180 A